# EUROPEAN PATENT APPLICATION

(11) **EP 1 777 325 A2**
(43) Date of publication of application: **25.04.2007**
(21) Application number: 06122314.5
(22) Date of filing: 16.10.2006
(51) Int. Cl.: C30B 29/40, C30B 25/02, H01L 21/205

(54) **Single crystalline a-plane nitride semiconductor wafer having orientation flat**

(30) Priority: 19.10.2005 KR 20050098379
(71) Applicant: Samsung Corning Co., Ltd, Suwon-si, Gyeonggi-do 443-732 (KR)
(72) Inventor: Shin, Hyun Min, 131-206, Seoul (KR); Lee, Ki Soo, Seochu-gu, 137-797, Seoul (KR)
(74) Representative: Bokinge, Ole

(57) **Abstract**

A single crystalline a-plane nitride semiconductor wafer includes one to three orientation flats in a crystalline direction, wherein a-plane ({11-20} plane) is formed as a main plane. Since plane orientation can easily be recognized, accuracy can be improved when a semiconductor device is formed on the nitride semiconductor wafer.

## Description

### BACKGROUND OF THE INVENTION

### 1. Field of the Invention

The present invention relates to a single crystalline a-plane nitride semiconductor wafer having an orientation flat as a plane orientation mark to easily recognize plane orientation.

### 2. Description of the Related Art

A nitride based single crystalline wafer, such as GaN, which is used as a freestanding plate to manufacture a semiconductor device, is mainly manufactured such that a GaAs wafer is removed after a GaN thick film is grown on the GaAs wafer, as disclosed in Japanese Patent Publication pyung 10-114600, or a sapphire wafer is removed after a GaN thick film is grown on the sapphire wafer, as disclosed in Japanese Patent Publication pyung10-256662.

A single crystalline nitride semiconductor wafer conventionally known is a nitride film of a c-plane ({0001} plane) grown on either a GaAs wafer of {111} plane or a sapphire wafer of c-plane ({0001}), and is grown by a method such as metal organic chemical vapor deposition (MOCVD), molecular beam epitaxy (MBE), or halide vapor phase epitaxy (HVPE).

However, such a single crystalline c-plane nitride film has polarity as a Ga layer and an N layer are repeatedly layered along a c-crystalline axis. For example, in the case of a GaN/AlGaN hetero structure, an electronic band structure in a hetero structure is varied due to a strong electric field generated by spontaneous polarization or piezoelectric polarization, thereby adversely affecting electrical optical characteristics of a semiconductor device. In other words, since polarization discontinuity exists in a growth direction of a c-crystalline axis, a fixed sheet charge is generated on a surface and a boundary, thereby resulting in an electric field. The electric field separates an electron hole wave function from electrons in a quantum well to emit light in a wavelength of the color red, and reduce quantum efficiency therein.

Conversely, since a-plane ({11-20} plane) nitride based crystals have non-polar characteristics, they can solve the aforementioned problem relating to quantum efficiency of the single crystalline c-plane nitride film. Since the a-plane nitride based crystals have no polarization field, band bending does not occur. Also, since the Stark effect is found in a structure where a quantum well of AlGaN/GaN is grown on a non-polar crystalline plane, an a-plane non-polar nitride based hetero structure can be used for a light emitting device of an ultraviolet-visible light area having high efficiency and a microwave transistor of high output.

Inventors of this application have manufactured a non-polar a-plane freestanding plate having a thickness greater than 300µm by separating a sapphire material from a single crystalline a-plane nitride after growing the single crystalline a-plane nitride on a single crystalline r-plane ({1-102} plane) sapphire using HVPE.

Also, when a semiconductor device is formed on a nitride semiconductor wafer, it is necessary to enhance accuracy of work by recognizing plane orientation of the nitride semiconductor wafer. In the case of the c-plane nitride semiconductor wafer conventionally used, there exists a study relating to recognition of the plane orientation, disclosed in Japanese Patent Publication No. 2002-222746. However, since there is no study relating to recognition of the plane orientation in the case of the a-plane nitride semiconductor wafer having orientation different from that of the c-plane nitride semiconductor wafer, a unique plane orientation mark is required.

Moreover, unlike the c-plane nitride semiconductor, since the a-plane nitride semiconductor has non-polarity, it is not necessary to distinguish inside and outside (front and back) of a main plane. However, it is necessary to allow surface roughness of the inside to differ from that of the outside in order to form an electrode required for manufacture of a semiconductor device. Accordingly, another plane orientation mark is additionally required to distinguish inside from outside.

### SUMMARY OF THE INVENTION

To solve the above described and/or other problems, the present invention provides a single crystalline a-plane nitride semiconductor wafer having an orientation flat, which easily recognizes plane orientation.

Additional aspects and/or advantages of the invention will be set forth in part in the description which follows and, in part, will be apparent from the description, or may be learned by practice of the invention.

According to an aspect of the present invention, a single crystalline a-plane nitride semiconductor wafer includes one to three orientation flats in a crystalline direction, wherein a-plane ({11-20} plane) is formed as a main plane.

### BRIEF DESCRIPTION OF THE DRAWINGS

These and/or other aspects and advantages of the invention will become apparent and more readily appreciated from the following description of the embodiments, taken in conjunction with the accompanying drawings of which:
FIG. 1 illustrates orientation of a single crystalline nitride semiconductor wafer having an a-plane ({11-20 plane}) as a main plane;
FIGS. 2A and 2B illustrate circular shaped single crystalline a-plane nitride semiconductor wafers having three flats in a crystalline direction;
FIGS. 3A through 3C illustrate oval shaped single crystalline a-plane nitride semiconductor wafers having one orientation flat in a crystalline direction; and
FIGS. 4A through 4C illustrate oval shaped single crystalline a-plane nitride semiconductor wafers having two orientation flats in a crystalline direction.

### DETAILED DESCRIPTION OF THE PREFERRED EMBODIMENTS

Reference will now be made in detail to embodiments of the present invention, examples of which are illustrated in the accompanying drawings, wherein like reference numerals refer to the like elements throughout. The embodiments are described below in order to explain the present invention by referring to the figures.

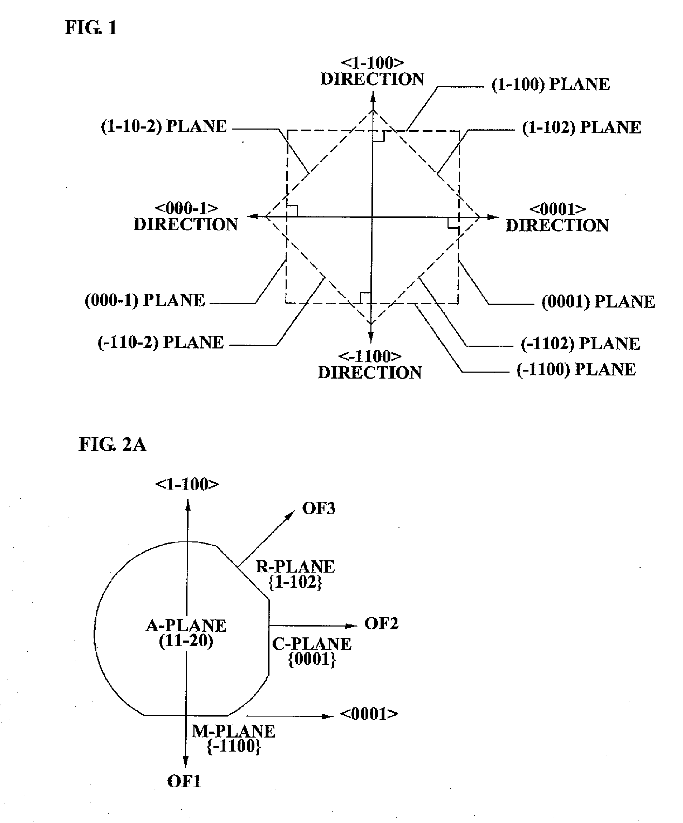

Orientation of a single crystalline nitride semiconductor wafer having an a-plane ({11-20 plane}) as a main plane is shown in FIG 1. Referring to FIG 1, the a-plane nitride semiconductor wafer has {1-100} plane ("m-plane") vertical to <1-100> direction, {0001} plane ("c-plane") vertical to <0001> direction, and {1-102} plane ("r-plane") as equivalent planes. In addition, the a-plane nitride semiconductor wafer has {-1100} plane, {000-1} plane and {-110-2} plane, which are respectively parallel with the m-plane, the c-plane and the r-plane (same in an angle). Moreover, the a-plane nitride semiconductor wafer has {1-10-2} plane and {-1102} plane, which are located at a right angle to the r-plane.

As described above, although the a-plane nitride semiconductor wafer has strictly eight equivalent planes distinguished from one another, the {1-100} plane and the {-1100} plane parallel with the {1-100} plane are all designated as the m-plane, the {0001} plane and the {000-1} plane parallel with the {0001} plane are all designated as the c-plane, and the {1-102} plane, the {-110-2} plane parallel with or at a right angle to the {1-102} plane, the {1-10-2} plane and the {-1102} plane are all designated as the r-plane. This is based on the fact that the same effect can be obtained when the planes have the same angle even though a specific direction or plane is replaced with an equivalent direction or plane.

The single crystalline a-plane nitride semiconductor according to the present invention has one orientation flat, two orientation flats or three orientation flats as specific marks indicating equivalent planes of the m-plane, the c-plane, and the r-plane, so that plane orientation or equivalent direction can be recognized.

Such an orientation flat is preferably formed at the end of the wafer in a predetermined length. When the orientation flat has a short length, it is preferable in that an effective area of the wafer increases. However, when the orientation flat is too short, it is difficult to check parallelism in a cleavage direction through the orientation flat. Accordingly, the orientation flat is preferably formed in a length of 5 mm to 15 mm with respect to a wafer having a diameter of 2 inch.

If the wafer according to the present invention has a circular shape, one to three orientation flats can be formed. Specifically, in the case of one orientation flat, the orientation flat is formed on any one of the m-plane, the c-plane, and the r-plane; in the case of two orientation flats, the orientation flats are formed on any one of the m-plane, the c-plane and the r-plane and its parallel equivalent plane; and in the case of three orientation flats, the orientation flats are formed on the m-plane, the c-plane, and the r-plane, and the r-plane is in contact with any one of the m-plane and the c-plane.

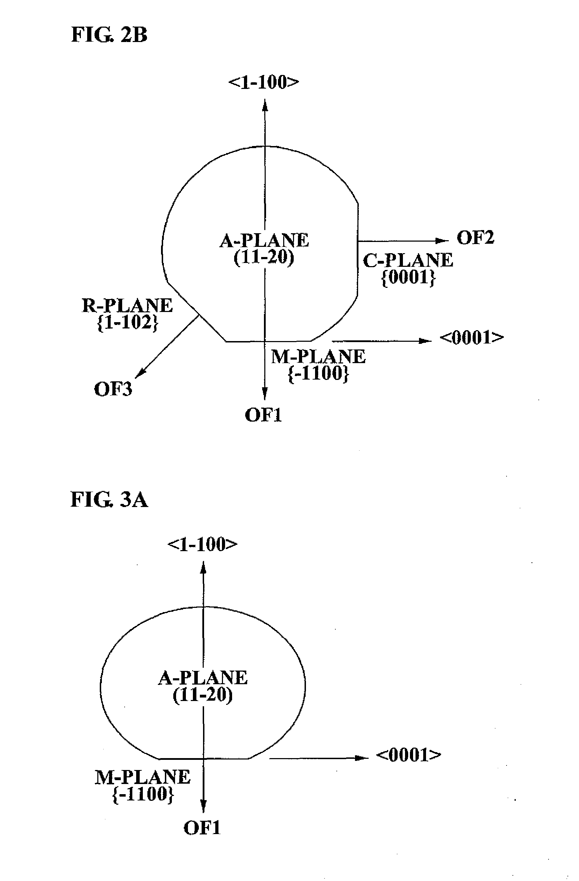

In the case of the three orientation flats, a circular wafer having orientation flats OF1, OF2, and OF3 with respect to the m-plane, the c-plane, and the r-plane, the r-plane being in contact with the c-plane is shown in FIG. 2A, and a circular wafer having orientation flats OF1, OF2 and OF3 with respect to the m-plane, the c-plane, and the r-plane, the r-plane being in contact with the m-plane is shown in FIG 2B.

If it is necessary to distinguish between inside and outside of the circular wafer, three orientation flats showing the m-plane, the c-plane, and the r-plane, the r-plane being in contact with any one of the m-plane and the c-plane, should be formed.

An oval wafer according to the present invention has a rectangular shape (long axis and minor axis) of which the minor axis is in <1-100> direction, and also may have one or two orientation flats. Specifically, in the case of one orientation flat, the orientation flat is formed on any one of the m-plane, the c-plane, and the r-plane; and in the case of two orientation flats, the orientation flats are formed on any two of the m-plane, the c-plane, and the r-plane.

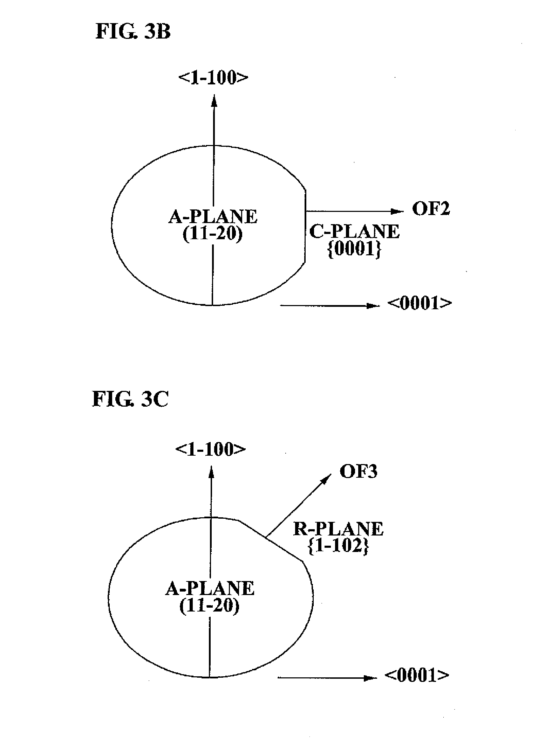

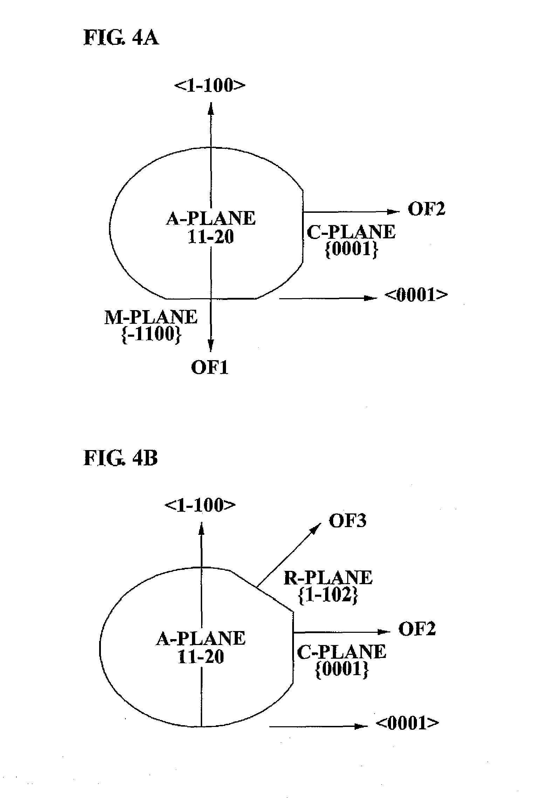

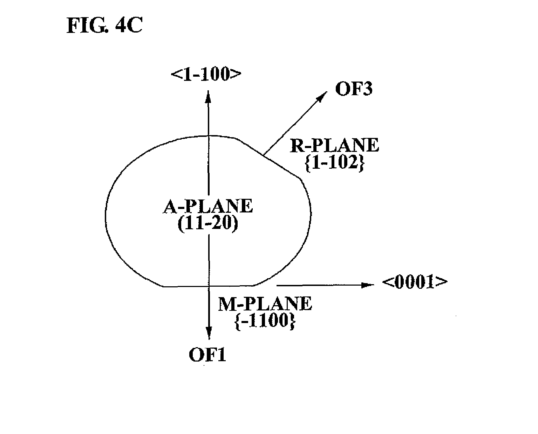

Examples of an oval wafer having one orientation flat are shown in FIGS. 3A through 3C, and examples of an oval wafer having two orientation flats are shown in FIGS. 4A through 4C.

If it is necessary to distinguish between the inside and the outside of the oval wafer, one orientation flat showing the r-plane or two orientation flats showing any two of the m-plane, the c-plane, and the r-plane should be formed.

In the present invention, the single crystalline a-plane nitride semiconductor wafer having one to three orientation flats in a crystalline direction can be obtained such that a single crystalline a-plane nitride semiconductor thick film is grown on a single crystalline r-plane sapphire material by using HVPE and then the sapphire material is removed. At this time, after the plane is cut and polished by measuring a plane orientation of the m-plane, the c-plane, and the r-plane using an X-ray goniometer, a desired orientation flat can be formed in the single crystalline r-plane sapphire material.

As described above, according to the single crystalline a-plane nitride semiconductor wafer having the orientation flat in the specific position, since the plane orientation can easily be recognized by only the wafer, accuracy can be improved when the semiconductor device is formed on the nitride semiconductor wafer.

Although a few embodiments of the present invention have been shown and described, the present invention is not limited to the described embodiments. Instead, it would be appreciated by those skilled in the art that changes may be made to these embodiments without departing from the principles and spirit of the invention, the scope of which is defined by the claims and their equivalents.

## Claims

1. A single crystalline a-plane nitride semiconductor wafer comprising one to three orientation flats in a crystalline direction, wherein a-plane ({11-20} plane) is formed as a main plane.

2. The single crystalline a-plane nitride semiconductor wafer of claim 1, wherein the orientation flats are formed at an end of the wafer.

3. The single crystalline a-plane nitride semiconductor wafer of claim 1, having a circular shape.

4. The single crystalline a-plane nitride semiconductor wafer of claim 3, wherein the orientation flat is formed on any one of m-plane, c-plane, and r-plane.

5. The single crystalline a-plane nitride semiconductor wafer of claim 3, wherein the orientation flats are formed on any one of m-plane, c-plane and r-plane, and any one of an equivalent parallel plane of the m-plane, an equivalent parallel plane of the c-plane and an equivalent parallel plane of the m-plane .

6. The single crystalline a-plane nitride semiconductor wafer of claim 3, wherein the orientation flats are formed on m-plane, c-plane, and r-plane, wherein the r-plane is in contact with any one of the m-plane and the c-plane.

7. The single crystalline a-plane nitride semiconductor wafer of claim 6, wherein inside is distinguished from outside.

8. The single crystalline a-plane nitride semiconductor wafer of claim 1, having an oval (elliptical) shape whose minor axis is in a direction of <1-100>.

9. The single crystalline a-plane nitride semiconductor wafer of claim 8, wherein the orientation flat is formed on any one of m-plane, c-plane, and r-plane.

10. The single crystalline a-plane nitride semiconductor wafer of claim 9, wherein inside is distinguished from outside as the orientation flat is formed on the r-plane.

11. The single crystalline a-plane nitride semiconductor wafer of claim 8, wherein the orientation flats are formed on any two of m-plane, c-plane, and r-plane.

12. The single crystalline a-plane nitride semiconductor wafer of claim 11, wherein inside is distinguished from outside.

13. A method for manufacturing a single crystalline a-plane nitride semiconductor wafer, comprising growing a single crystalline a-plane nitride semiconductor thick film on a single crystalline r-plane sapphire material having one to three orientation flats by using halide vapor phase epitaxy (HVPE) and removing the sapphire material.

14. The method of claim 13, wherein the orientation flats are formed in the single crystalline r-plane sapphire material through a polishing process after they are cut by measuring plane orientation using an X-ray goniometer.
